# NEUE EUROPÄISCHE PATENTSCHRIFT

(11) **EP 0 844 678 B2**
(45) Veröffentlichungstag und Bekanntmachung des Hinweises auf die Entscheidung über den Einspruch: **31.08.2011**
(45) Hinweis auf die Patenterteilung: 14.08.2002
(21) Anmeldenummer: 97119858.5
(22) Anmeldetag: 13.11.1997
(51) Int. Cl.: H01L 41/047, H01L 41/083

(54) **Aussenelektrode für einen monolithischen Vielschichtaktor**
Outer electrode for a monolitic multilayer actuator
Electrode externe pour un organe d'actionnement monolithique multicouches

(30) Priorität: 25.11.1996 DE 19648545
(43) Veröffentlichungstag der Anmeldung: 27.05.1998
(73) Patentinhaber: CeramTec AG Innovative Ceramic Engineering, 73207 Plochingen (DE)
(72) Erfinder: Bindig, Reiner, 95463 Bindlach (DE); Günther, Andreas, Dr., 91233 Speikern (DE); Helke, Günther, Dr., 91207 Lauf (DE); Schmieder, Jürgen, 91207 Lauf (DE)
(74) Vertreter: Scherzberg, Andreas Hans

(56) Entgegenhaltungen:
- EP-A- 0 569 235
- EP-A1- 0 655 790
- EP-A2- 0 479 328
- WO-A1-98/20872
- DE-A1- 3 330 538
- DE-A1- 3 832 658
- DE-C2- 3 422 935
- JP-A- 07 106 653
- JP-A- 07 226 541
- JP-A- 07 283 453
- JP-A- 08 250 777
- US-A- 4 012 588
- US-A- 4 917 484
- 'Handbook of Chemistry & Physics', Bd. 56, CRC PRESS, INC, CLEVELAND, OHIO Artikel 'Commercial Metals and Alloys', Seiten D171 - D172
- DR.OTTO-ALBRECHT NEUMÜLLER: 'RÖMPPS CHEMIE-LEXIKON', FRANCKH'SCHE VERLAG, STUTTGART Seite 3213
- DR.OTTO-ALBRECHT NEUMÜLLER: 'RÖMPPS CHEMIE-LEXIKON', FRANCKH'SCHE VERLAG, STUTTGART Seiten 3328 - 3701
- 'Werkstoff-und Verfahrenstechnik' PROCEEDINGS WERKSTOFFWOCHE '96 FRANKFURT 1997, Seiten 431 - 438

## Beschreibung

Die Erfindung betrifft einen monolithischen Vielschichtaktor.

Bei Piezokeramiken wird der Effekt ausgenutzt, dass diese sich unter einem mechanischen Druck bzw. Zug aufladen und andererseits bei elektrischer Aufladung ausdehnen bzw. zusammenziehen. Zur Verstärkung dieses Effekts werden monolithische Vielschichtaktoren verwendet, die aus einem gesinterten Stapel dünner Folien aus Piezokeramik (z. B. Bleizirkonattitanat) mit eingelagerten metallischen Innenelektroden bestehen. Die Innenelektroden sind wechselseitig aus dem Stapel herausgeführt und über Außenelektroden elektrisch parallel geschaltet. Auf den Kontaktseiten des Stapels ist hierzu eine Grundmetallisierung aufgebracht, die mit den einzelnen Innenelektroden verbunden ist. Durch flächiges bzw. partielles Überdecken der Grundmetallisierung mit Lot wird diese verstärkt. Zum einen wird durch diese Verstärkung der notwendige Materialquerschnitt hergestellt um die beim Betrieb des Aktors auftretenden hohen Ströme zu tragen (ca. 20 - 80 Ampere). Zum anderen wird das Anlöten von elektrischen Zuleitungen ermöglicht.

Legt man eine elektrische Spannung an die Außenelektroden, so dehnen sich die Piezofolien in Feldrichtung aus. Durch die mechanische Serienschaltung der einzelnen Piezofolien wird die Nenndehnung der gesamten Piezokeramik schon bei niedrigen elektrischen Spannungen erreicht.

Die genannten monolithischen Vielschichtaktoren sind ausführlich in der DE 40 36 287 C2 beschrieben. Hier ist auch die Verwendung in einem Strömungsdurchsatz-Regulierventil angegeben.

Piezokeramik ist von Natur aus spröde und hat nur eine geringe Zugfestigkeit (ca. 80 10⁶ Pa). Diese wird bei Vielschichtaktoren durch die laminare Anordnung der Innenelektroden und die beim Polarisieren auftretende Anisotropie der Festigkeit weiter reduziert. Die maximal zulässige Zugspannung wird oftmals bereits beim Polarisieren überschritten, so dass unweigerlich Rissbildung auftritt.

Es gibt jedoch keinen Hinweis darauf, dass diese Art von Rissbildung unter normalen Betriebsbedingungen zum Ausfall der Aktoren führt.

Das Risswachstum innerhalb der Keramik kann zudem durch Korngröße, Korngrenzenzusammensetzung und Porosität gut beeinflusst werden. Unter günstig eingestellten Bedingungen verlaufen Risse nicht transkristallin und werden schnell von Energiesenken an Korngrenzen und Poren gestoppt. Bereits nach ca. 1.000 Belastungszyklen ist das Risswachstum weitgehend abgeschlossen und nimmt auch nach langen Betriebszeiten (10⁹ Zyklen) nur noch geringfügig zu.

Kritisch können diese Risse jedoch bei hohen dynamischen Belastungen der Vielschichtaktoren werden, wenn nämlich die Risse in der Keramik die Grundmetallisierung und die aufgebrachte Lotschicht durchtrennen. Im günstigsten Falle sind dann nur einzelne Piezofolien abgetrennt. Wesentlich häufiger kommt es jedoch an der Risskante zu Spannungsüberschlägen, die zu einer Zerstörung des Vielschichtaktors führen, da der gesamte an dieser Stelle fließende Betriebsstrom abgetrennt wird.

EP 0 569 235 A1 beschreibt ein piezoelektrisches Element in Form eines Vibrators, bei dem die elektrischen Anschlüsse nicht über eine Lötung mit einer leitfähigen Oberfläche des Elements verbunden sind, da dies zu mechanischen Problemen führen soll. Aus diesem Grund erfolgt die Verbindung über eine Art Reibkupplung.

US 4,012,588 beschreibt ein System zum Übertragen der Stellung eines Gegenstands in Bezug auf ein vorbestimmtes Bezugssystem. Außerdem ist für dieses System ein spezieller Wandler beschrieben. Dieser besteht aus einem hohlen Zylinder aus piezoelektrischem Material, der jeweils auf seiner Innen- und Außenseite eine dünne leitende Schicht aufweist. Die elektrische Verbindung von Anschlussdrähten zu der dünnen leitenden Schicht auf der Außenseite erfolgt über ein wellenförmiges Federelement. Dieses Federelement liegt locker auf der dünnen leitenden Schicht auf und ist an den Kontaktstellen mit dieser nicht durch Löten, Kleben mit Leitkleber oder Schweißen, z. B. Laserschweißen verbunden. Das Federelement in dieser Ausführungsform dient lediglich zur Vibrationsentkoppelung. Es kann aufgrund der fehlenden "fixierten" Verbindung keine hohen Ströme übertragen und ist nicht für einen Vielschichtaktor geeignet.

Der Erfindung liegt daher die Aufgabe zugrunde, einen monolithischen Vielschichtaktor derart zu verbessern, dass auch bei hohen dynamischen Belastungen keine Zerstörung des Vielschichtaktors eintritt.

Erfindungsgemäß wird diese Aufgabe durch die Merkmale des Anspruchs 1 gelöst, wobei zwischen der Grundmetallisierung und den Anschlusselementen eine dreidimensional strukturierte, elektrisch leitende Elektrode angeordnet ist, die über partielle Kontaktstellen mit der Grundmetallisierung verbunden ist und zwischen den Kontaktstellen dehnbar ausgebildet ist. Durch diese Anordnung wird der Betriebsstrom des Aktors in Nebenströme aufgeteilt. Die Nebenströme fließen von den Kontaktstellen über die Grundmetallisierung zu den metallischen Innenelektroden und betrage typischerweise 0,5 Ampere. Für diese Ströme ist eine Verstärkung der Grundmetallisierung nicht notwendig.

Durch diese erfindungsgemäße Ausbildung wird in Kauf genommen, daß während des dynamischen Betriebs des Aktors die Grundmetallisierung Risse bekommen kann. Diese Risse können sich jedoch nicht in die dreidimensional strukturierte Elektrode fortpflanzen, da diese nur über partielle Kontaktstellen mit der Grundmetallisierung verbunden ist und zwischen den Kontaktstellen dehnbar ausgebildet ist. Der elektrische Kontakt bleibt dadurch immer erhalten, weil der in der dreidimensionalen Elektrode fließende Betriebsstrom keinesfalls unterbrochen wird. Die in der Grundmetallisierung auftretenden Risse führen nur zu einer Umlenkung der Nebenströme über die dreidimensionale Elektrode.

Unter einer dynamischen Belastung wird das Anlegen einer Wechselspannung verstanden. Die Stärke der dynamischen Belastung ist abhängig von der Flankensteilheit der einzelnen Impulse und der Frequenz. Bei hohen dynamischen Belastungen liegt die Flankensteilheit typischerweise bei 10 bis 500 µs, die Frequenz typischerweise zwischen 10 bis 1000 Hz. Versuche, auch Langzeitversuche, haben ergeben, daß bei diesen dynamischen Belastungen keine Ausfälle der erfindungsgemäßen Vielschichtaktoren zu verzeichnen waren.

Die Elektrode hebt zwischen den Kontaktstellen von der Grundmetallisierung ab und ist zweckmäßigerweise eine strukturierte Metallfolie. Diese Folien mit einer Dicke von ca. 50 µm sind dehnbar und eignen sich vorzüglich für die erfindungsgemäße Elektrode.

Das Abheben von der Grundmetallisierung ist einfach zu erreichen, wenn die Elektrode einen wellenförmigen Querschnitt aufweist. Auch - von oben gesehen - ein Fischgrätmuster eignet sich vorzüglich.

Damit die Elektrode etwas von der Grundmetallisierung absteht, ist vorteilhafterweise die Elektrode an den Kontaktstellen mit Noppen versehen. Ebenso zweckmäßig ist es, wenn die Elektrode mit Durchbrüchen für Waschprozesse der Grundmetallisierung versehen ist. Durch die Waschprozesse lässt sich verwendetes Flussmittel einwandfrei entfernen.

In bevorzugter Ausführungsform ist die Elektrode als Kühlkörper ausgebildet. Dies vermindert die thermische Belastung des Aktors.

Die Elektrode kann auch zweckmäßigerweise ein Drahtgewirk, Drahtgeflecht oder ein offenporiger Metallschaum sein.

Erfindungsgemäß ist die Elektrode an den Kontaktstellen durch Löten, Kleben mit Leitkleber oder Schweißen z. B. Laserschweißen mit der Grundmetallisierung verbunden.

Als Material für die Elektrode hat sich Bronze oder Messing als besonders vorteilhaft erwiesen.

Weitere Merkmale der Erfindung ergeben sich aus den Figuren, die nachfolgend beschrieben sind. Es zeigt:
- Fig. 1: schematisch einen Vielschichtaktor nach dem Stand der Technik
- Fig. 2: einen Querschnitt durch einen Vielschichtaktor nach dem Stand der Technik, der durch einen Riss unbrauchbar geworden ist,
- Fig. 3: einen Schnitt durch einen erfiridungsgemäßen Aktor mit einer strukturierten wellenförmigen Elektrode,
- Fig. 4: einen Aktor mit einem Drahtgewirk als Elektrode,
- Fig. 5: einen Aktor mit einem Metallschaum als Elektrode,
- Fig. 6: eine Draufsicht auf eine im Querschnitt wellenförmige Elektrode, ähnlich Fig. 3,
- Fig. 7: eine Draufsicht auf eine Elektrode mit einem Fischgrätmuster und
- Fig. 8: einen Schnitt entlang der Linie A-A in einem Wellental in Fig. 6.

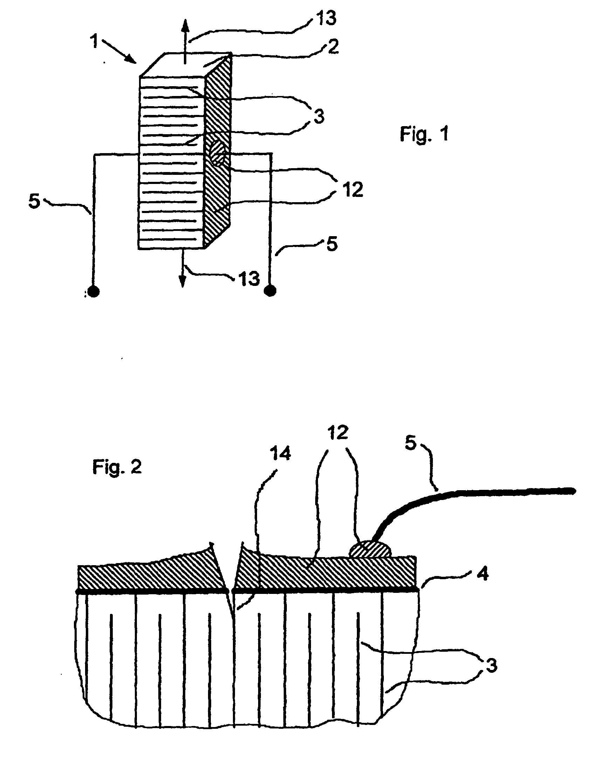

Fig. 1 zeigt schematisch einen Vielschichtaktor nach dem Stand der Technik. Der Stapel 2 besteht aus gesinterten Folien aus einer Piezokeramik mit eingelagerten metallischen Innenelektroden 3. Die Elektroden 3 sind wechselseitig aus dem Stapel herausgeführt und über Außenelektroden elektrisch parallel geschaltet.

Fig. 2 zeigt im Schnitt einen Ausschnitt aus dem Vielschichtaktor. Zur Parallelschaltung ist auf den Kontaktseiten des Stapels 2 eine Grundmetallisierung 4 aufgebracht. Auf dieser Grundmetallisierung 4 sind über Lötungen bzw. Lote 12 die Anschlußelemente 5 befestigt. Beim Anlegen einer Spannung an die Anschlußelemente 5 dehnt sich der Stapel 2 in Richtung der Pfeile 13 aus. Wird eine Wechselspannung entsprechender Leistung angelegt, so vollführt der Stapel im Takt der Wechselfrequenz eine Dehn- und Schrumpfbewegung.

Durch diese dynamische Belastung treten in der Keramik leicht Risse 14 auf, die im ungünstigsten Falle die Grundmetallisierung 4 und die aufgebrachte Lotschicht 12 durchtrennen.

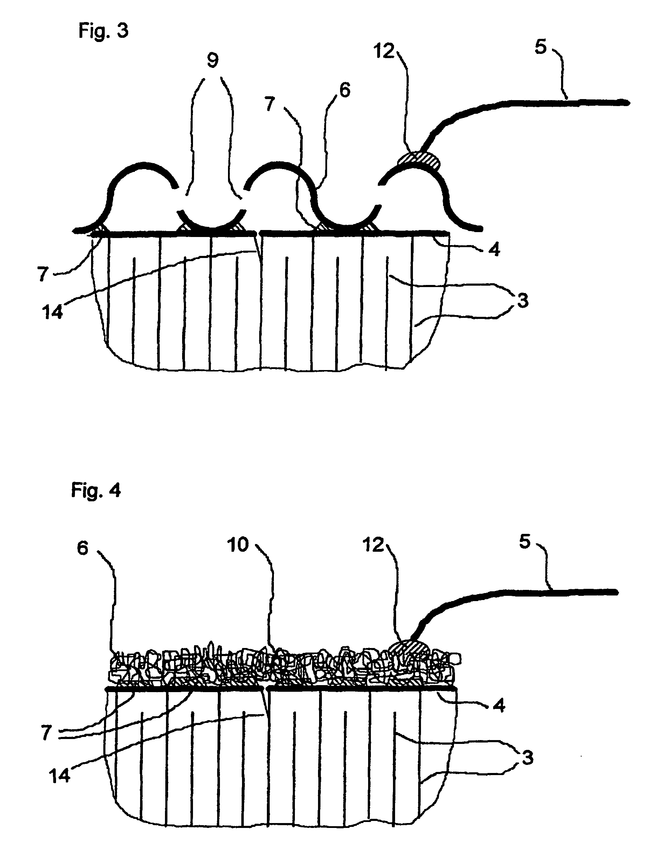

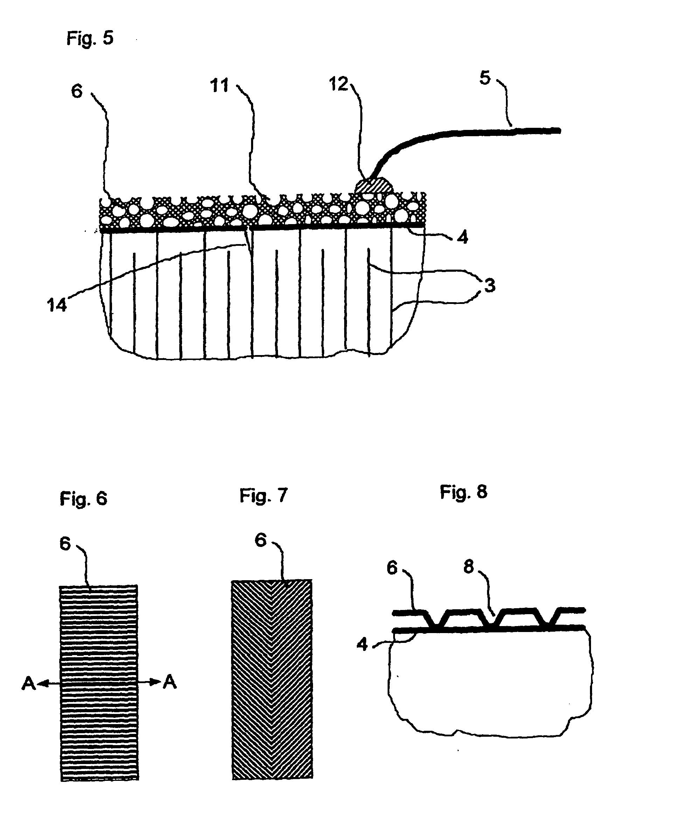

Fig. 3 zeigt einen Schnitt ähnlich Fig. 2 durch einen erfindungsgemäßen Vielschichtaktor mit einer mit der Grundmetallisierung 4 verbundenen wellenförmigen dreidimensionalen Elektrode 6. Fig. 6 zeigt eine Draufsicht auf diese Elektrode 6, die aus parallel angeordneten Wellentälern und Wellenbergen besteht. Diese Elektrode 6 ist an Kontaktstellen 7 mit der Grundmetallisierung 4 elektrisch leitend verbunden, z. B. durch eine Laserschweißung. Zur Reinigung der Grundmetallisierung 4 sind in der Elektrode 6 Durchbrüche 9 angeordnet. In der Fig. 3 sind beispielhaft einige dieser Durchbrüche 9 gezeigt. Die Elektrode 6 besteht bevorzugt aus einer Metallfolie aus z. B. Bronze oder Messing. Wichtig ist hierbei, daß der Bereich zwischen den Kontaktstellen 7 dehnbar ist, so daß keine Brüche in der Elektrode 6 aufgrund von Rissen 14 in der Keramik auftreten können. Durch die große Oberfläche der Elektrode 6 läßt sich diese vorteilhaft als Kühlkörper für den Vielschichtaktor verwenden. Die Anschlußelemente 5 können an irgendeiner Stelle mit der Elektrode 6 verbunden werden.

Fig. 4 zeigt einen Aktor mit einem Drahtgewirk 10 als Elektrode 6. Die einzelnen Kontaktstellen bzw. Lötungen des Drahtgewirks 10 mit der Grundmetallisierung sind wieder mit dem Bezugszeichen 7 gekennzeichnet. Es ist gut zu erkennen, daß ein Riß 14 zu keiner Durchtrennung der Elektrode 6 führt, da der Riß 14 elektrisch durch die Elektrode 6 überbrückt wird.

Fig. 5 zeigt einen Aktor mit einem Metallschaum 11 als Elektrode 6. Der Metallschaum 11 ist bevorzugt offenporig ausgebildet. Die Kontaktstellen bzw. die einzelnen Lötpunkte sind hier der einfachheithalber nicht eingezeichnet. Ansonsten bezeichnen dieselben Bezugszeichen gleiche Gegenstände.

Fig. 6 zeigt, wie schon beschrieben, in Draufsicht eine wellenförmige Elektrode 6. Die Wellenzüge verlaufen hier geradlinig und sind parallel angeordnet.

In Fig. 7 ist in Draufsicht eine Elektrode 6 mit einem Fischgrätmuster gezeigt. Auch hier ist jeweils einem Wellental ein Wellenberg benachbart angeordnet.

Fig. 8 zeigt einen Schnitt entlang der Linie A-A in einem Wellental in Fig. 6. Die Elektrode 6 berührt hier mit Noppen 8 die Grundmetallisierung.

Es sind für einen Fachmann diverse andere Elektrodenformen denkbar, wobei immer sichergestellt sein muß, daß die Elektrode nur über eine Anzahl von Kontaktstellen, d. h. nicht vollflächig die Grundmetallisierung berührt und der Zwischenbereich zwischen zwei Kontaktstellen in Bezug auf die Ausdehnung und Kontraktion des Stapels eine gewisse Dehnung ausführen kann, so daß die Elektrode 6 in diesem Bereich bei einem auftretenden Riß in der Keramik nicht durchtrennt wird.

## Patentansprüche

1. Monolithischer Vielschichtaktor (1) aus einem gesinterten Stapel (2) dünner Folien aus Piezokeramik mit eingelagerten metallischen Innenelektroden (3), die wechselseitig aus dem Stapel (2) herausführen und über Außenelektroden elektrisch parallel geschaltet sind, wobei die Außenelektroden auf den Kontaktseiten des Stapels (2) aus einer aufgebrachten Grundmetallisierung (4) bestehen, die mit elektrischen Anschlußelementen (5) bevorzugt über eine Lötung verbunden sind, zwischen der Grundmetallisierung (4) und den Anschlußelementen (5) eine dreidimensional strukturierte, elektrisch leitende Elektrode (6) angeordnet ist, die über partielle Kontaktstellen (7) mit der Grundmetallisierung verbunden ist und zwischen den Kontaktstellen (7) dehnbar ausgebildet ist, und die Elektrode (6) an den Kontaktstellen (7) durch Löten, Kleben mit Leitkleber oder Schweißen, z. B. Laserschweißen mit der Grundmetallisierung (4) verbunden ist.

2. Vielschichtaktor nach Anspruch 1 oder 2, **dadurch gekennzeichnet, dass** die Elektrode (6) eine strukturierte Metallfolie ist.

3. Vielschichtaktor nach einem der Ansprüche 1 bis 3, **dadurch gekennzeichnet, dass** die Elekrode (6) einen wellenförmigen Querschnitt aufweist.

4. Vielschichtaktor nach einem der Ansprüche 1 bis 4, **dadurch gekennzeichnet, dass** die Elektrode (6) an den Kontaktstellen (7) mit der Grundmetallisierung (4) mit Noppen (8) versehen ist.

5. Vielschichtaktor nach einem der Ansprüche 1 bis 5, **dadurch gekennzeichnet, dass** die Elektrode (6) mit Durchbrüchen (9) für Waschprozesse der Grundmetallisierung (4) versehen ist.

6. Vielschichtaktor nach einem der vorhergehenden Ansprüche, **dadurch gekennzeichnet, dass** die Elektrode (6) als Kühlkörper ausgebildet ist.

7. Vielschichtaktor nach einem der vorhergehenden Ansprüche, **dadurch gekennzeichnet, dass** die Elektrode (6) ein Drahtgewirk /Drahtgeflecht (10) oder ein offenporiger Metallschaum (11) ist.

8. Vielschichtaktor nach einem der vorhergehenden Ansprüche, **dadurch gekennzeichnet, dass** die Elektrode (6) aus Bronze oder Messing hergestellt ist.

## Claims

1. A monolithic multilayer actuator (1) consisting of a sintered stack (2) of thin films made of piezoceramic with interleaved metallic internal electrodes (3) that are led out of the stack (2) alternately and are electrically connected in parallel via external electrodes, wherein the external electrodes consist, on the contact sides of the stack (2), of a deposited base metallisation (4) and are connected to electrical connection elements (5) preferably via a soldered joint, arranged between the base metallisation (4) and the connection elements (5) there is a three-dimensionally patterned, electrically conducting electrode (6) that is connected to the base metallisation via partial contact points (7) and is expansibly constructed between the contact points (7), and between the contact points (7) the electrode (6) rises from the base metallisation (4), and the electrode (6) is connected to the base metallisation (4) at the contact points (7) by soldering, gluing with conductive adhesive or welding, for example laser welding.

2. A multilayer actuator according to claim 1, **characterised in that** the electrode (6) is a patterned metal film.

3. A multilayer actuator according to claim 1 or 2, **characterised in that** the electrode (6) has an undulating cross-section.

4. A multilayer actuator according to one of claims 1 to 3, **characterised in that** the electrode (6) is provided with nubs (8) at the contact points (7) with the base metallisation (4).

5. A multilayer actuator according to one of claims 1 to 4, **characterised in that** the electrode (6) is provided with openings (9) for washing processes of the base metallisation (4).

6. A multilayer actuator according to one of the preceding claims, **characterised in that** the electrode (6) is constructed as a heat sink.

7. A multilayer actuator according to one of the preceding claims, **characterised in that** the electrode (6) is a woven wire fabric/wire mesh (10) or an open-cell metal foam (11).

8. A multilayer actuator according to one of the preceding claims, **characterised in that** the electrode (6) is made from bronze or brass.

## Revendications

1. Actionneur multicouche (1) monolithique formé d'un empilage (2) fritté de feuilles minces de piézo-céramique avec des électrodes internes (3) métalliques intercalées, qui sortent en alternance de l'empilage (2) et sont connectées électriquement en parallèle au moyen d'électrodes externes, dans lequel les électrodes externes sur les faces de contact de l'empilage (2) sont formées d'une métallisation de base (4), et sont reliées à des éléments de connexion (5), de préférence par une brasure, dans lequel une électrode (6) électro-conductrice à structure tri-dimensionnelle est disposée entre la métallisation de base (4) et les éléments de connexion (5), est reliée à la métallisation de base par des points de contact (7) partiels et est extensible entre les points de contact (7), dans lequel l'électrode (6), au niveau des points de contact (7), est reliée à la métallisation de base (4) par brasage, collage à l'aide d'une colle conductrice ou par soudage, par exemple par soudage au laser.

2. Actionneur multicouche selon la revendication 1, **caractérisé en ce que** l'électrode (6) est une feuille de métal structurée.

3. Actionneur multicouche selon une des revendications 1 ou 2, **caractérisé en ce que** l'électrode (6) présente en section une forme d'ondes.

4. Actionneur multicouche selon une des revendications 1 à 3, **caractérisé en ce que** l'électrode (6), au niveau des points de contact (7) avec la métallisation de base (4), est pourvue de surélévations en forme de boutons (8).

5. Actionneur multicouche selon une des revendications 1 à 4, **caractérisé en ce que** l'électrode (6) est pourvue de passages (9) pour des processus de bain de la métallisation de base (4).

6. Actionneur multicouche selon une des revendications précédentes, **caractérisé en ce que** l'électrode (6) est conformée en radiateur.

7. Actionneur multicouche selon une des revendications précédentes, **caractérisé en ce que** l'électrode (6) est une structure de fils tricotée/tissée (10) ou une mousse métallique (11) à pores ouverts.

8. Actionneur multicouche selon une des revendications précédentes, **caractérisé en ce que** l'électrode (6) est en bronze ou en laiton.
